# EUROPEAN PATENT APPLICATION

(11) **EP 2 192 208 A1**
(43) Date of publication of application: **02.06.2010**
(21) Application number: 08777038.4
(22) Date of filing: 30.05.2008
(51) Int. Cl.: C23C 16/44

(54) **DEPOSITION APPARATUS**

(71) Applicant: Toyo Seikan Kaisha, Ltd., Tokyo 100-8522 (JP)
(72) Inventor: KOISHI, Ryousuke, Yokohama-shi Kanagawa 230-0001 (JP); GONDA, Toshiaki, Yokohama-shi Kanagawa 230-0001 (JP); TAKAHASHI, Yoshihiro, Hiki-gun Saitama 355-0193 (JP)
(74) Representative: Müller-Boré & Partner Patentanwälte
(86) International application number: PCT/JP2008/060027
(87) International publication number: WO 2009/144814

(57) **Abstract**

[Problems] To provide a vapor deposition apparatus capable of greatly shortening the time for vapor-depositing a film on the containers in spite of using the existing vacuum vapor deposition apparatus.

[Means for Solution] The vapor deposition apparatus has a rotary body 14 that can rotates about a rotary shaft. A plurality of vapor deposition units are arranged surrounding and facing the rotary body 14, and microwave oscillators 34 are arranged at positions facing the circumferential portion of the rotary body 14. While the vapor deposition units 15 are turning and moving from a position where the containers are fed into chamber bodies 16 of the vapor deposition units 15 to a container vapor deposition position, the pressures in the containers 25 and in the treating chambers 24 are pre-reduced by a vacuum device and after the vacuum deposition units have approached the oscillators 34 at the container vapor deposition position, the pressures in the containers and in the treating chambers are mainly reduced. Vapors are deposited on the containers due to the microwave oscillators 34.

## Description

### Technical Field:

This invention relates to a vapor deposition apparatus for vapor-depositing a film on the containers.

### Background Art:

A patent document 1 described below is disclosing a CVD apparatus equipped with conveyer means. The conveyer means is provided with a circular conveyer surface which is so constituted as to move about a rotary shaft that is directed in the up-and-down direction. The conveyer surface is divided into four regions in the circumferential direction, each region being provided with a holder and a coating facility, and a casing holding a plurality of parts such as plastic bottles on which a film is to be deposited is fed to the coating facility via the holder.
On the outer side of the conveyer means, there are determined a feed position where the casing is fed to the holder facing the conveyer means, a discharge(pressure-reducing) position where a pump is disposed for reducing the pressure in the coating facility prior to the vapor deposition treatment, a coating position where there are arranged means for forming microwaves for depositing a film on the parts in the coating facility and a pump for reducing the pressure in the coating facility, and an unloading position where the casing is conveyed from the holder. At these positions, there are provided facilities for executing their respective operations.

The operation executed by the vapor deposition apparatus is such that after the casing is fed to the coating facility via the holder of the conveyer means at the position for feeding the casing, the pressure in the coating facility is reduced by the pump at the discharge position attained by rotating the conveyer means by a predetermined angle. After the pressure is reduced in the coating facility, the conveyer means is further rotated by a predetermined angle to convey the casing to the coating position where there is provided a portion for installing means that generates microwaves. At the coating position, the pressure in the coating facility is reduced by the pump down to a predetermined pressure and, thereafter, the parts are coated by the coating means. After the coating operation has been finished, the conveyer means is further rotated by a predetermined angle to convey the casing to the unloading position where the casing is taken out from the conveyer means.
Patent document 1: JP-A-2004-3027

### Disclosure of the Invention:

### Problems that the Invention is to Solve:

To coat the parts, the pressure in the coating facility is reduced down to a predetermined pressure, and the parts are coated. In the step of coating, much of the time is used by the operation for reducing the pressure and the coating treatment.
In the coating apparatus of the patent document 1, a plurality of parts are treated by one coating facility. Therefore, an extended period of time is required for reducing the pressure in the coating facility, and the operation time is required at the coating position. On the other hand, the time required for introducing the casing into the conveyer means and for conveying it out therefrom is shorter than the times required for the operation for reducing the pressure and for the coating treatment. Therefore, despite the casing has been conveyed onto the conveyer means at the position of feeding the casing and the casing has already been conveyed out from the conveyer means at the position of unloading the casing, the operation of reducing the pressure and the coating treatment are still continuing at the position of coating.

At the position of feeding the casing, therefore, the casings stand by on the conveyer means deteriorating the working efficiency. In the coating apparatus of the patent document 1, in particular, a plurality of parts are treated in one coating facility (treating chamber) requiring a further extended period of time for reducing the pressure. Besides, since a plurality of parts are coated at one time in one coating facility (treating chamber), it is difficult to form a coating on the parts maintaining good precision and uniformity and, besides, the apparatus tends to become bulky.
It is an object of the present invention to provide a vapor deposition apparatus capable of greatly shortening the time for vapor-depositing a film on the containers without causing the apparatus to become bulky and of uniformalizing the coating in spite of using the existing container feeding/taking-up device, vapor deposition unit, vacuum device and microwave oscillator.

### Means for Solving the Problems:

The inventors of the present application have paid attention to that in the coating apparatus of the patent document 1, a long period of time is consumed by the operation at the position of coating and there exists a standby period before the conveyer means is conveyed to a next step, and have, therefore, completed the vapor deposition apparatus of the invention which greatly shortens the operation time at the position of coating (vapor deposition) and shortens the standby time as much as possible offering a high operation efficiency.

In order to achieve the above object, the vapor deposition apparatus of the present invention comprises a support plate capable of intermittently rotating; a plurality of vapor deposition units equipped with a treating chamber that can be opened and closed being arranged on the support plate in the circumferential direction thereof maintaining a distance so as to be successively positioned in an introduction/discharge zone, a pressure pre-reducing zone, a vapor deposition zone and a reduced pressure release zone accompanying the intermittent rotation of the support plate; to-be-vapor-deposited body introduction/discharge means which discharges a body on which a thin film has been vapor-deposited from the treating chamber of the vapor deposition unit positioned in the introduction/discharge zone and introduces a to-be-vapor-deposited body on which a thin film is to be vapor-deposited into the treating chamber of the vapor deposition unit from which the to-be-deposited body has been discharged; pressure pre-reducing means for exhausting the interior of the treating chamber of the vapor deposition unit positioned in the pressure pre-reducing zone to reduce the pressure therein; vapor deposition means including main pressure-reducing means for exhausting the interior of the treating chamber to reduce the pressure therein to vapor-deposit a film on the to-be-vapor-deposited body present in the treating chamber of the vapor deposition unit positioned in the vapor deposition zone, gas feed means for feeding a gas necessary for vapor-depositing a film into the treating chamber, and electromagnetic wave generating means for generating electromagnetic waves in the treating chamber; and reduced pressure release means for releasing the state of a reduced pressure in the treating chamber of the vapor deposition unit positioned in the reduced pressure release zone.
It is desired that the vapor deposition unit in the vapor deposition apparatus includes a base plate and a chamber body, the chamber body moves up and down with respect to the base plate to specify a close position where the treating chamber is closed and an open position where the treating chamber is opened, the chamber body moves to the close position while the vapor deposition unit is moving from the introduction/discharge zone to the pressure pre-reducing zone or after the vapor deposition unit is positioned in the pressure pre-reducing zone, and the chamber body moves to the open position after the vapor deposition unit is positioned in the reduced pressure release zone.
It is desired that the pressure pre-reducing means in the vapor deposition apparatus comprises a first flow passage arranged in the base plate of the vapor deposition unit, and is communicated at the one end thereof with the treating chamber, is opened at the other end thereof, and has first opening/closing valve means on the way thereof; a second flow passage arranged in a first vacuum exhaust system, and is opened at the one end thereof, communicated at the other end thereof with a first vacuum source, and has second opening/closing valve means on the way thereof; and a first moving member which enables the first flow passage and the second flow passage to be so positioned as connected to each other or disconnected from each other; wherein at the time of reducing the pressure in the treating chamber of the vapor deposition unit positioned in the pressure pre-reducing zone, the first opening/closing valve means and the second opening/closing valve means are opened from a state where the first opening/closing valve means is closed, the second opening/closing valve means is closed and the first flow passage and the second flow passage are connected together by the first moving member and, thereafter, at the time of moving the vapor deposition unit from the pressure pre-reducing zone to the vapor deposition zone, the first and second opening/closing valve means are closed, respectively, and, thereafter, the first flow passage and the second flow passage are disconnected from each other by the first moving member.
It is desired that the main pressure reducing means in the vapor deposition apparatus comprises a first flow passage arranged in the base plate of the vapor deposition unit, and is communicated at the one end thereof with the treating chamber, is opened at the other end thereof, and has first opening/closing valve means on the way thereof; a third flow passage arranged in a second vacuum exhaust system, and is opened at the one end thereof, communicated at the other end thereof with a second vacuum source, and has third opening/closing valve means on the way thereof; and a second moving member which enables the first flow passage and the third flow passage to be so positioned as connected to each other or disconnected from each other; wherein at the time of reducing the pressure in the treating chamber of the vapor deposition unit positioned in the main pressure reducing zone, the third opening/closing valve means is opened from a state where the first opening/closing valve means is closed, the third opening/closing valve means is closed and the first flow passage and the third flow passage are connected together by the second moving member and, next, the first opening/closing valve means is opened, and, thereafter, at the time of moving the vapor deposition unit from the vapor deposition zone to the reduced pressure release zone, the first and second opening/closing valve means are closed, respectively, and, thereafter, the first flow passage and the third flow passage are disconnected from each other by the second moving member.
It is desired that the to-be-vapor-deposited body in the vapor deposition apparatus is a synthetic resin container, and a thin film is vapor-deposited on the whole inner surface of the container.

### Effects of the Invention:

The vapor deposition apparatus of the present invention comprises a support plate capable of intermittently rotating, and a plurality of vapor deposition units arranged on the support plate in the circumferential direction thereof maintaining a distance so as to be successively positioned in an introduction/discharge zone, a pressure pre-reducing zone, a vapor deposition zone and a reduced pressure release zone accompanying the intermittent rotation of the support plate. The vapor deposition apparatus of the invention makes it possible to shorten the operation time in the vapor deposition zone, to shorten the standby time in the introduction/discharge zone enabling the operation time to be substantially equalized in each of the stages and, therefore, the operation time for effecting the vapor deposition on the to-be-vapor-deposited body to be shortened as a whole. That is, the introduction and discharge of the to-be-vapor-deposited bodies are carried out in one stage, and the reduced pressure after the vapor deposition is released not in the vapor deposition zone but in an independent isolated stage, making it possible to greatly shorten the operation time in the vapor deposition zone and, therefore, to equalize the operation time in the four stages.

### Brief Description of the Drawings:

[Fig. 1] is a schematic plan view of a vapor deposition system equipped with a vapor deposition apparatus according to an embodiment of the invention.
[Fig. 2] is an enlarged plan view of the vapor deposition apparatus of Fig. 1.
[Fig. 3] is an enlarged front view of the vapor deposition apparatus of Fig. 1.
[Fig. 4] is an enlarged side view of a portion where a microwave oscillator of the vapor deposition apparatus of Fig. 1 can be seen.
[Fig. 5] is an enlarged sectional view of a vapor deposition unit in the vapor deposition apparatus shown in Figs. 3 and 4.
[Fig. 6] is a sectional view of when a base plate in a second stage of the vapor deposition apparatus and a vacuum exhaust system of Fig. 1 are viewed from a side surface thereof.
[Fig. 7] is a sectional view of when the base plate in the second stage of the vapor deposition apparatus and the vacuum exhaust system of Fig. 1 are viewed from the direction of a plane thereof.
[Fig. 8] is a sectional view of when the base plate in the second stage of the vapor deposition apparatus and the vacuum exhaust system of Fig. 1 are viewed from the direction of a back surface thereof (direction of a line Y-Y in Fig. 6).
[Fig. 9] is a sectional view of when a base plate in a third stage of the vapor deposition apparatus and the vacuum exhaust system of Fig. 1 are viewed from the direction of a side surface thereof.
[Fig. 10] is a sectional view of when the base plate in the third stage of the vapor deposition apparatus and the vacuum exhaust system of Fig. 1 are viewed from the direction of a back surface thereof (cross section in the third stage corresponding to the direction of the line Y-Y in Fig. 6).
[Fig. 11] is a schematic connection diagram illustrating a starting gas connection portion connected to the base plate.
[Fig. 12] shows the results of test for determining the standby times necessary for reducing the pressures in the flow passages in the base plate under the atmospheric pressure condition in the third stage of the vapor deposition apparatus of Fig. 1.
[Fig. 13] is a diagram illustrating the times in a cycle of operation for effecting the vapor deposition on a container in the vapor deposition apparatus according to the embodiment. Description of Reference Numerals:

- 1: vapor deposition apparatus
- 2: feed conveyer
- 3: container feed wheel
- 3a, 7a: rotary shafts
- 3b, 7a: wheels
- 3c: gear
- 4: conveyer wheel
- 5, 6: container introduction/discharge devices
- 7: container discharge wheel
- 8: discharge conveyer
- 9: inner conveyer passage
- 9a, 10a: container support portions
- 10: outer conveyer passage
- 12: outer frame
- 14: rotary body
- 14a: outer circumferential surface
- 14b: support plate
- 14c: pole-like portion
- 15: vapor deposition unit
- 16: chamber body
- 16a, 17a: sealing members
- 17: base plate
- 18: lift unit
- 18a: guide rail
- 21: guide block
- 23: top lid
- 24: treating chamber
- 25: container
- 27: starting material gas feed rod
- 28: container support portion
- 29, 31: intake/exhaust ports
- 30: starting material gas feed pipe
- 32: waveguide
- 32a: R-type flange portion
- 32b: vacuum shielding plate
- 34: microwave oscillator
- 35: microwave oscillator power source
- 40: slide valve portion (first opening/closing valve means)
- 41a to 41c: flow passages
- 42: slide plate
- 43: vacuum shut-off valve
- 44a to 44c: valve seats
- 45a to 45c: lower end openings
- 58, 59a to 59c: vacuum flanges
- 61: vacuum exhaust system (first vacuum exhaust system)
- 62, 72: upper plates
- 63: bellows-like piping (first moving member)
- 64: vacuum valve portion (second opening/closing valve means)
- 65, 75a to 75c: exhaust flow passages
- 66, 76: cylinders
- 71: vacuum exhaust system (second vacuum exhaust system)
- 73a to 73c: bellows-like pipings (second moving members)
- 74a to 74c: vacuum valve portions (third opening/closing valve means)
- 81, 83: opening/closing valves
- 82: starting material gas container
- 84: starting material gas tank
- 85: air feed means
- 89, 90: starting material gas flow rate adjusting valves
- 86, 91: inlet flow passages
- 87, 88: atmosphere release valves
- 95: vacuum pump (first vacuum source)
- 96, 97: vacuum pumps (second vacuum sources)
- f, h: container hand-over areas (container hand-over positions)

### Best Mode for Carrying Out the Invention:

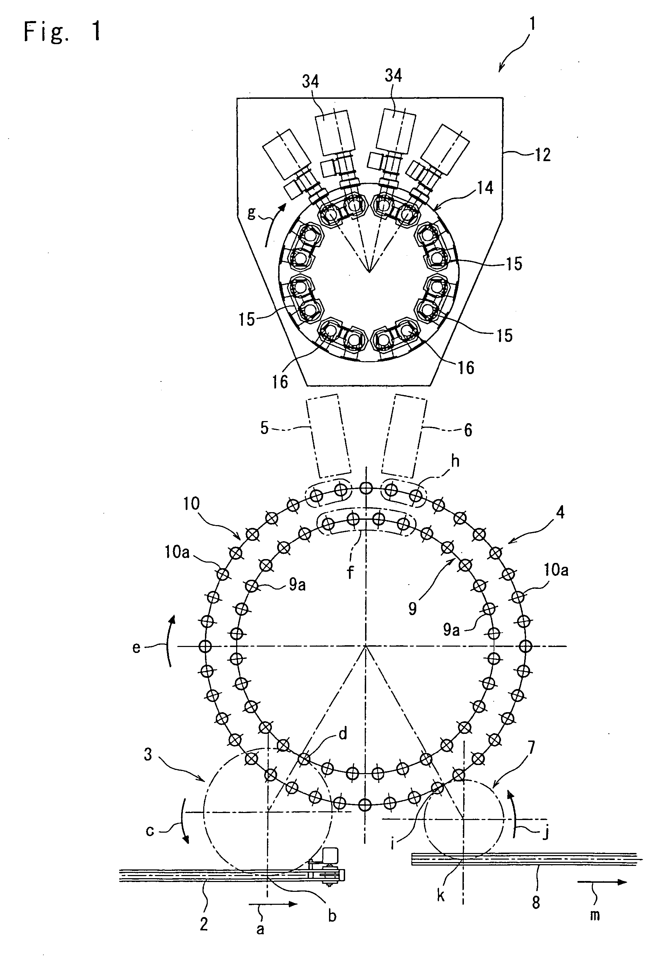

Fig. 1 is a plan view of a vapor deposition system of when the vapor deposition operation is conducted being divided into four stages in a vapor deposition apparatus 1 for containers according to an embodiment of the invention.
The vapor deposition system according to the present invention is to vapor-deposit starting material gases on the inner surfaces of containers such as PET bottles by utilizing microwaves. The containers flow through a feed conveyer 2, a container feed wheel 3, a conveyer wheel 4, container introduction/discharge devices (robots) 5 and 6 up to a vapor deposition apparatus 1 that are successively positioned from the upstream side toward the downstream side of the vapor deposition system, and are returned back again to the conveyer wheel 4 via the container introduction/discharge devices 5 and 6, and flow from the conveyer wheel 4 onto a container discharge wheel 7 and a discharge conveyer 8.

The feed conveyer 2 conveys the containers in a linear direction of an arrow a in an erected attitude with their openings facing upward. The container feed wheel 3 has container grip portions, rotates about a rotary shaft in the counterclockwise direction of an arrow c, and receives the containers at a hand-over position b of the feed conveyer 2. The conveyer wheel 4 has a circular inner conveyer passage 9 and an outer conveyer passage 10 on the same rotary shaft, the inner and outer conveyer passages 9 and 10 rotating in the clockwise direction indicated by an arrow e, and having a plurality of container support portions 9a, 10a arranged in the whole circumferential direction. The circular track of the container support portions 9a of the inner conveyer passage 9 comes in contact with the circular track of the container feed wheel 3 at the hand-over position d so that the containers are handed over.

The pitch between the container support portions 9a of the inner conveyer passage 9 of the conveyer wheel 4 is the same as the pitch between the container support portions of the container feed wheel 3 arranged in the circumferential direction thereof. Further, the container support portions 10a of the outer conveyer passage 10 are arranged in the circumferential direction thereof maintaining the same pitch as the pitch of the container support portions 9a. The inner conveyer passage 9 and the outer conveyer passage 10 are so constituted as to rotate independently of each other.
The conveyer wheel 4 conveys the containers up to a hand-over area f of the inner conveyer passage 9, and hands the containers over to the introduction/discharge devices 5 and 6. The introduction/discharge devices 5 and 6 use robots of a known technology, move about the rotary shafts thereof to invert the container grip portions, receive the containers conveyed in an erected attitude from the container support portions 9a of the inner conveyer passage 9, turn the attitude of the containers by 180 degrees, and feed the containers in an inverted state to the vapor deposition apparatus 1.

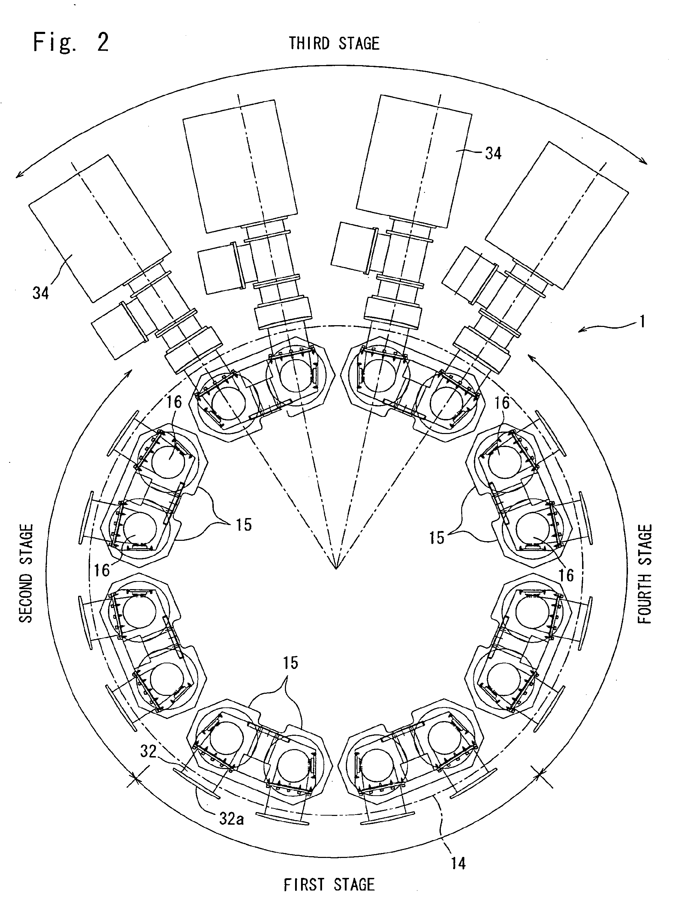

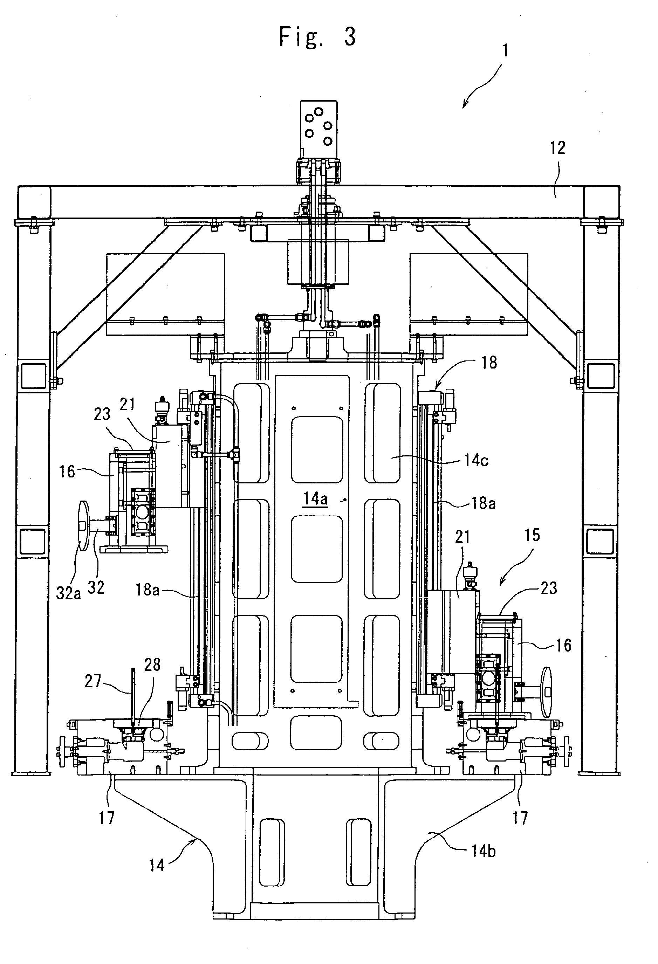

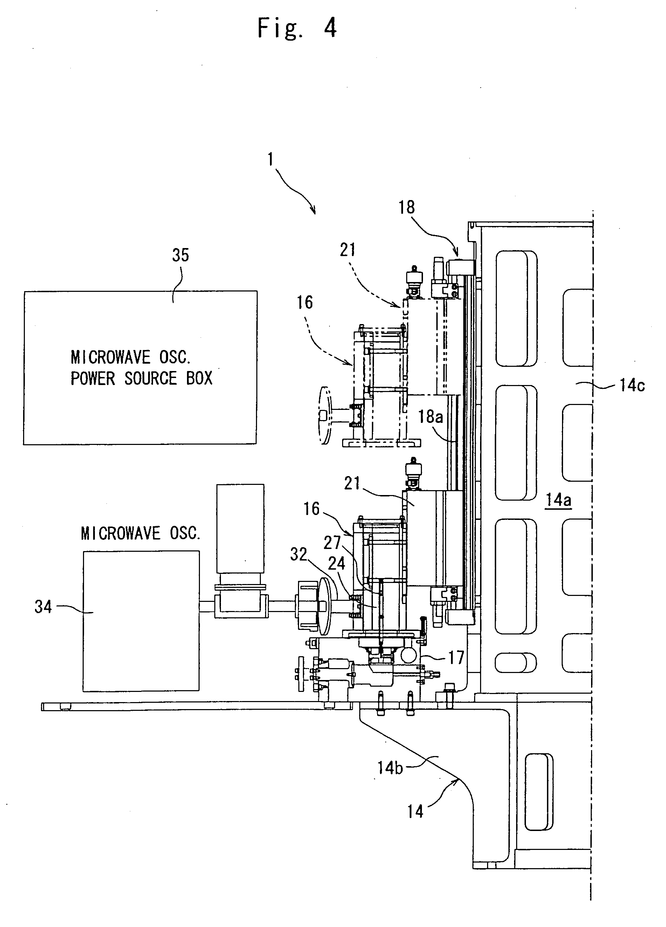

Fig. 2 is an enlarged plan view of the vapor deposition apparatus, Fig. 3 is a front view of the vapor deposition apparatus, and Fig. 4 is a side view thereof of when viewed from a portion where there is a microwave oscillator.
The vapor deposition apparatus 1 is provided with a square outer frame 12, and a rotary body 14 is disposed in the outer frame 12. The rotary body 14 includes a support plate 14b and a pole-like portion 14c, the upper end side of the support plate 14b being so formed as to extend toward the upper outer side. A horizontal surface is formed on the upper portion thereof. The pole-like portion 14c is arranged on the support plate 14b. The rotary body 14 rotates in the clockwise direction of an arrow g (see Fig. 1), and a plurality of vapor deposition units 15 are arranged along the outer circumferential portion of the support plate 14b that extends in the vertical direction. In this embodiment, the vapor deposition units 15 are arranged in a number of sixteen in the circumferential direction of the rotary body 14, each pair of the vapor deposition units 15 forming a set. The vapor deposition units 15 move about the center axis of the rotary body 14 along a track in the circumferential direction.

The vapor deposition unit 15 includes a chamber body 16 positioned on the upper side and a base plate 17 positioned on the lower side. Due to a lift unit 18, the chamber body 16 moves up and down in the vertical direction along the outer circumferential surface 14a of the pole-like body 14c. The lift unit 18 has a guide rail 18a that extends up and down on the outer circumferential surface 14a of the pole-like body 14c, and a guide block 21 is fitted to the guide rail 18a so as to slide. The lift unit 18 causes the guide block 21 to move up and down by using drive means such as of hydraulic pressure, air pressure or drive motor. The guide block 21 supports a set of chamber bodies 16 so as to move the chamber bodies 16 to an ascended position or a descended position.

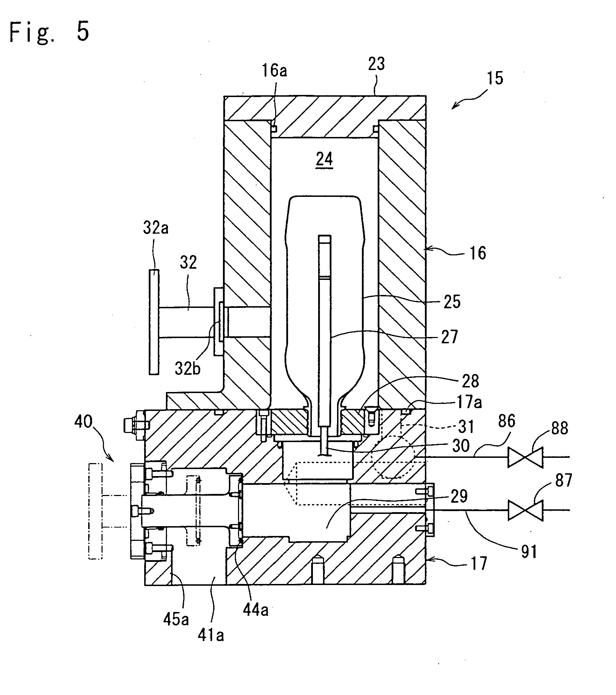

Fig. 5 is a schematic sectional view illustrating a state where the chamber body 16 is at the descended position, i.e., illustrating a state where the chamber body 16 and the base plate 17 are integrally coupled together and a container 25 is supported in the treating chamber 24. The base plate 17 of the vapor deposition unit 15 is fixed just under the chamber body 16, and moves in the circumferential direction together with the rotary body 14.
In the vapor deposition unit 15, a sealing member 17a is mounted on a seal-attaching portion formed between the chamber body 16 and the base plate 17; i.e., the sealing member 17a is provided so as to maintain the treating chamber 24 air-tight. An intake/exhaust port 31 is connected, via an exhaust pipe, to the base plate 17, the intake/exhaust port 31 being communicated with a vacuum pump which exhausts the treating chamber 24 to reduce the pressure therein.
The base plate 17 is provided with a support portion for supporting the mouth-and-neck portion of the container 25, and supports the container 25 with the mouth-and-neck portion being arranged on the lower side. In the container 25 is inserted a starting material gas feed rod 27 that is studded on a container support portion 28. The base plate 17 is, further, provided with an intake/exhaust port 29 for reducing the pressure in the container 25.

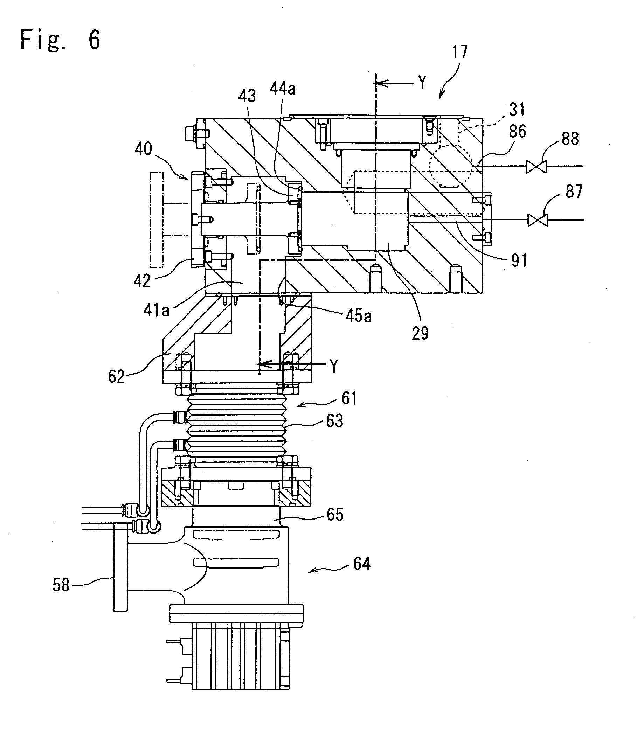

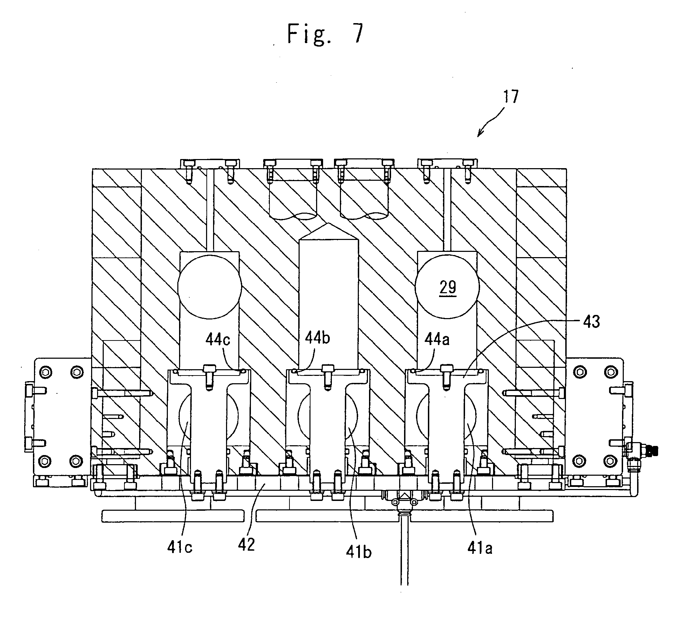

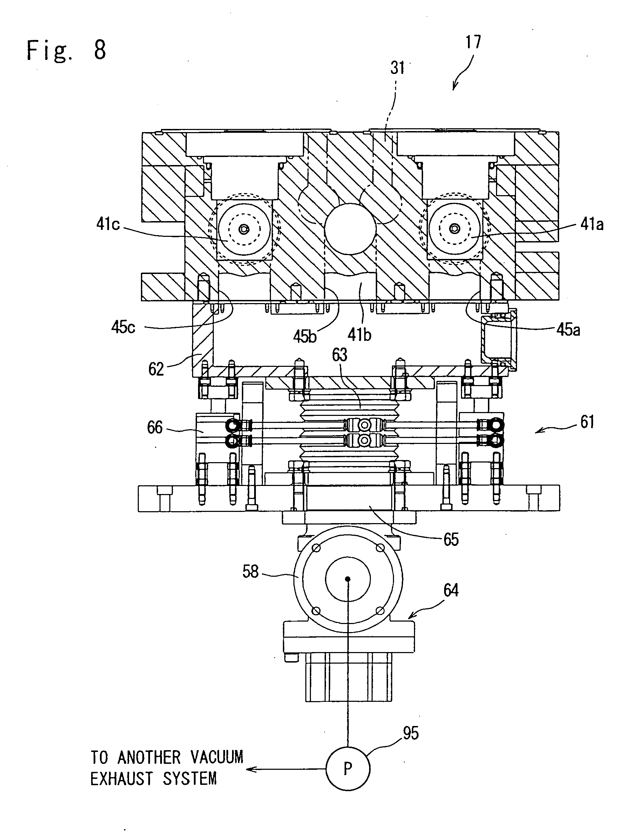

Fig. 6 to Fig. 8 illustrate the base plate 17 and a vacuum exhaust system 61 disposed in a second stage (see Fig. 2) for reducing the pressure in the treating chamber 24 of the vapor deposition unit and in the container, Fig. 6 being a side view of the base plate 17 and the vacuum exhaust system 61, Fig. 7 being a plan view thereof, and Fig. 8 being a back view thereof.
In the base plate 17, there are provided flow passages 41a and 41c communicated with an intake/exhaust port 29 on the side of the container 25, and a flow passage 41b communicated with an intake/exhaust port 31 on the side of the treating chamber 24. A slide valve portion 40 is disposed for the flow passages 41a to 41c. The flow passages 41a to 41c and the valve structures disposed therefor are substantially of the same structures as described below collectively.
The slide valve portion 40 is provided with a slide plate 42 linked to a cylinder that is not shown and a vacuum shut-off valve 43 linked to the slide plate 42. Due to the cylinder, the vacuum shut-off valve 43 moves back and forth in a horizontal direction and, at its advanced position, comes in contact with valve seats 44a to 44c formed in the flow passages 41a to 41c to close them and to shut off the flow of gas in the flow passages 41a to 41c and, at its retreated position, is opened to permit the flow of gas in the flow passages 41a to 41c. Lower end openings 45a to 45c are formed at the lower end portions of the flow passages 41a to 41c.

The vacuum exhaust system 61 disposed in the second stage (see Fig. 2) is detachably placed on the bottom surface of the base plate 17, and has an upper plate 62 at an upper end portion thereof. A bellows-like piping 63 and a vacuum valve portion 64 are disposed at a lower portion of the upper plate 62, and a flow passage 65 is provided between them. The upper plate 62 can move up and down due to a cylinder 66 and, at its ascended position, is air-tightly linked to the lower end openings 45a to 45c of the base plate 17 so that the flow passages 41a to 41c, bellows-like piping 63 and flow passage 65 on the downstream side are communicated with each other. The flow passages 41a to 41c on the side of the base plate 17 meet together in the upper plate 62.
When the upper plate 62 is at its descended position, the base plate 17 and the vacuum exhaust system 61 are separated from each other, and the lower end openings 45a to 45c of flow passages 41a to 41c on the side of the base plate 17 are communicated with the atmosphere. The bellows-like piping 63 is expansible and permits the upper plate 62 to move up and down.
A vacuum flange 58 is provided in the side portion of the vacuum valve portion 64 and is connected to a vacuum pump 95. Upon being opened and closed, the vacuum valve portion 64 permits and interrupts the flow of the air between the vacuum pump 95 and the flow passage 65. The vacuum pump 95 reduces the pressure in the treating chamber 24 and in the container 25 in a state where the slide valve portion 40 and the vacuum valve portion 64 are opened.

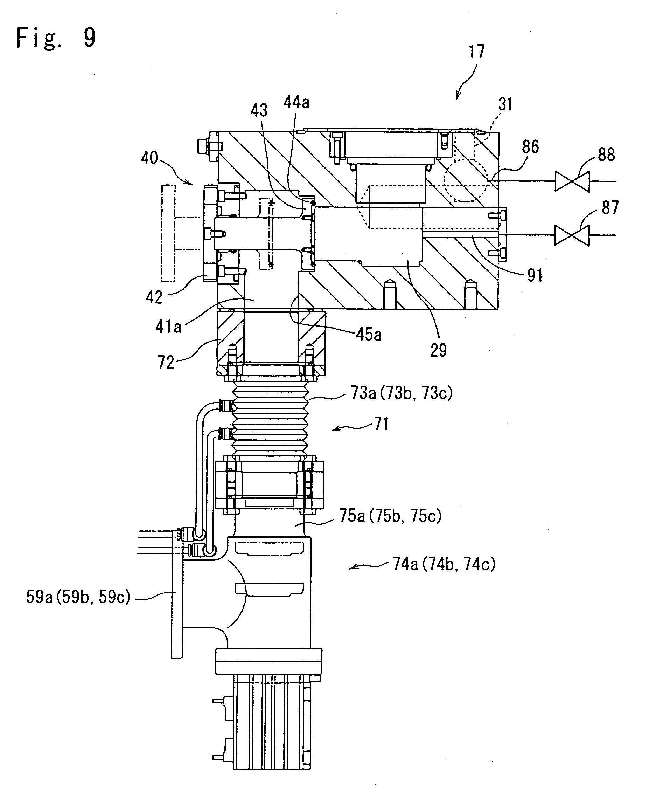

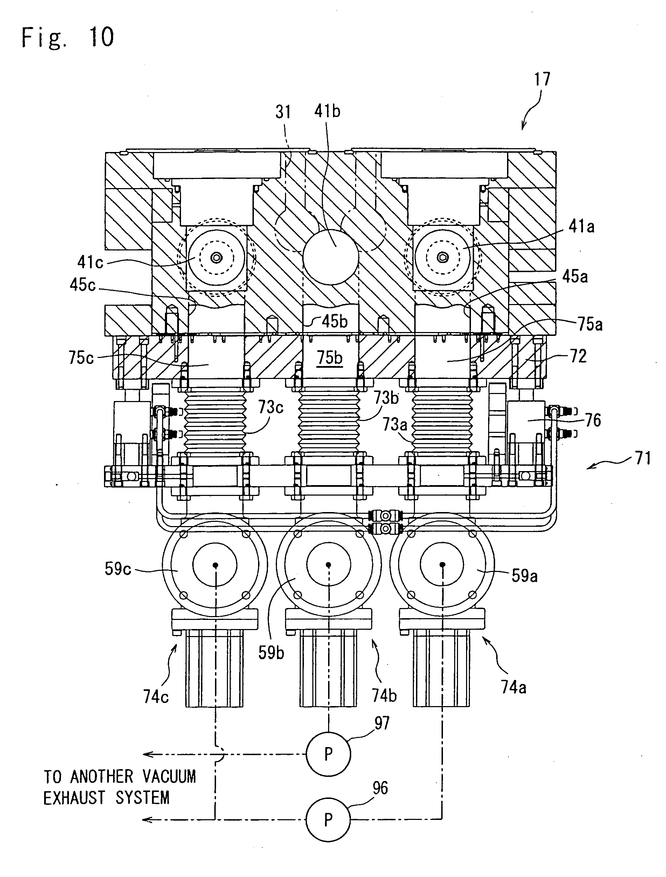

Fig. 9 and Fig. 10 illustrate the base plate 17 and a vacuum exhaust system 71 disposed in a third stage.
The vacuum exhaust system 71 is detachably disposed at a lower part of the base plate 17, and is provided with an upper plate 72 at an upper end portion thereof. At a lower part of the upper plate 72, there are disposed bellows-like pipings 73a to 73c and vacuum valve portions 74a to 74c. There are, further, provided flow passages 75a to 75c for communicating them with the bellows-like pipings 73a to 73c. The upper plate 72 is so constituted as can be moved up and down by hydraulic (or air pressure) cylinders 76 at both ends thereof and, at its ascended position, so works that the lower end openings 45a to 45c of the base plate 17 are air-tightly linked to the flow passages 75a to 75c in the vacuum exhaust system 71. When the upper plate 72 is at its descended position, the base plate 17 is separated away from the vacuum exhaust system 71, and the lower end openings 45a to 45c of the flow passages 41a to 41c are communicated with the atmosphere. The bellows-like pipings 73a to 73c are extensible and permit the upper plate 72 to move up and down.

Vacuum flanges 59a to 59c are provided at the side portions of the vacuum valve portions 74a to 74c. Among them, the vacuum flanges 59a and 59c positioned on the right and left outer sides are connected to a vacuum pump 96, and a vacuum pump 97 is connected to the central vacuum flange 59b. The vacuum valve portions 74a and 74c permit and interrupt the flow of gas between the vacuum pump 96 and the flow passages 75a, 75c, while the vacuum valve portion 74b permits and interrupts the flow of gas between the vacuum pump 97 and the flow passage 75b. The vacuum pump 96 reduces the pressure in the container 25 in a state where the slide valve portion 40 and the vacuum valve portions 74a, 74c are opened, while the vacuum pump 97 reduces the pressure in the treating chamber 24 in a state where the slide valve portion 40 and the vacuum valve portion 74b are opened.

The difference between the vacuum exhaust system 61 of the second stage and the vacuum exhaust system 71 of the third stage is that the second stage has only one vacuum pump 95 that is connected to the flange 58 while the third stage has two vacuum pumps. In the vacuum exhaust system 61 of the second stage shown in Fig. 8, the flow passages 41a to 41c of the intake/exhaust port 29 communicated with the container 25 and of the intake/exhaust port 31 communicated with the treating chamber 24 meet together in order to simultaneously reduce the pressures in the treating chamber 24 and in the container 25 by one vacuum pump 95 through the flow passage 65. In practice, two base plates 17 are installed on each stage, and two treating chambers 24 and two containers 25 are provided on one base plate 17. Accordingly, four treating chambers 24 and four containers 25 can be pre-exhausted simultaneously by one vacuum pump 95.
In the vacuum exhaust system 71 of the third stage, two vacuum pumps 96 and 97 are connected, i.e., the vacuum pump 96 is connected to the vacuum flanges 59a, 59c and the vacuum pump 97 is connected to the vacuum flange 59b.

As described above, four treating chambers 24 and four containers 25 are provided for each stage. Upon communicating the flow passages, therefore, the pressures in the four containers 25 can be simultaneously reduced by one vacuum pump 96, and the pressures in the four treating chambers 24 can be simultaneously reduced by one vacuum pump 97. As described above, a total of three vacuum pumps are disposed in the vapor deposition apparatus 1, i.e., one vacuum pump 95 in the second stage and two vacuum pumps 96 and 97 in the third stage.
The interior of the container 25 is more highly evacuated than the interior of the treating chamber 24. In the third stage, therefore, the vacuum pump 96 for reducing the pressure in the container 25 is capable of more highly reducing the pressure than vacuum pump 97 for reducing the pressure in the treating chamber 24.

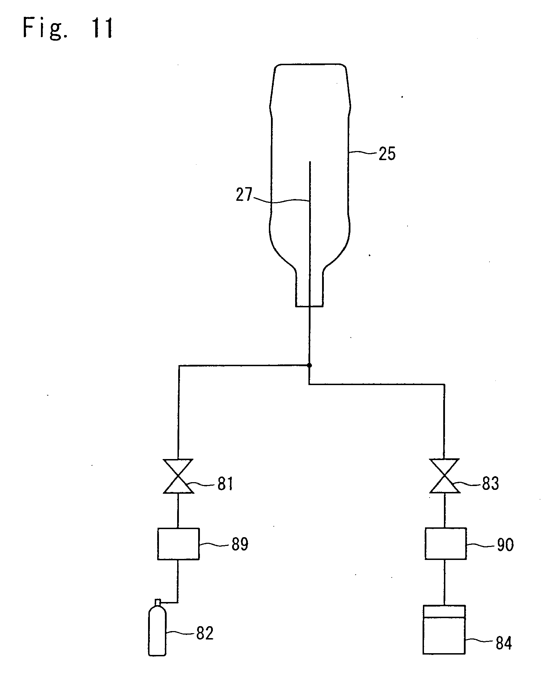

To the starting material gas feed rod 27, there is linked a starting material gas feed pipe 30 that feeds the starting material gases. The starting material gas feed rod 27 has a number of holes formed therein to emit the gases.
Referring to Fig. 11, a starting material gas container 82 filled with oxygen is connected to the starting material gas feed rod 27 via an opening/closing valve 81 and a starting material gas flow rate-adjusting valve 89. Further, a starting material gas tank 84 filled with an HMDSO (hexamethyldisiloxane) is connected thereto via an opening/closing valve 83 and a starting material gas flow rate-adjusting valve 90.
The base plate 17 is provided with an inlet flow passage 91 communicated with the intake/exhaust port 29, and an atmosphere release valve 87 is connected to the inlet flow passage 91. Further, an inlet flow passage 86 is provided being communicated with the intake/exhaust port 31, and an atmosphere release valve 88 is connected to the inlet flow passage 86.

In the side wall of the chamber body 16 is provided a waveguide 32 communicated with the treating chamber 24. The waveguide 32 is provided at its end portion with a disk-shaped R-type flange portion 32a. To maintain air-tightness of the treating chamber 24, a vacuum shielding plate 32b air-tightly closes an end of the waveguide 32. A microwave oscillator 34 is joined to the R-type flange portion 32a. The vacuum shielding plate 32b may be made of any material that permits the passage of microwaves, such as Teflon (registered trademark), ceramics or quartz glass.

The microwave oscillator 34 is fixed at a stationary position. The vapor deposition apparatus 1 of this embodiment is provided with four microwave oscillators. Referring to Fig. 1, the microwave oscillators 34 are arranged at positions opposite to the introduction/discharge devices 5 and 6 in the direction of diameter of the rotary body 14. The four microwave oscillators 34 are arranged being corresponded to the four chamber bodies 16 that are consecutively arranged in the circumferential direction. Referring to Fig. 4, further, a microwave oscillator power source 35 for oscillating microwaves is connected to the microwave oscillators 34. Microwaves are introduced into the treating chambers 24 via waveguide 32 to effect the vapor deposition on the four containers 25 simultaneously.

The container introduction/discharge devices 5 and 6 are capable of feeding the containers 25 to the base plate 17 while taking them out therefrom. The introduction/discharge devices 5 and 6 feed the containers 25 to, and take them out from, the two base plates 17 indicated as the first stage (introduction/discharge zone) in Fig. 2. That is, the introduction/discharge devices 5 and 6 hand the containers 25 over to the outer conveyer passage 10 in a hand-over area h of the conveyer wheel 4. The outer conveyer passage 10 rotates in the clockwise direction of an arrow e to convey the containers 25, and hand the containers at a hand-over position i over to grip means that are not shown of the container discharge wheel 7.
The container discharge wheel 7 rotates in the counterclockwise direction of an arrow j and hands over the containers 25 at a hand-over position k of a discharge conveyer 8 that extends in a tangential direction in which the container discharge wheel 7 rotates. The discharge conveyer 8 conveys the containers 25 in a linear direction of an arrow m.

The operation of the vapor deposition apparatus of the invention will be described next.
As described above, the containers 25 are successively conveyed by the feed conveyer 2 arranged on the upstream side of the vapor deposition system. The container 25 is gripped by one of the plurality of grip portions which are not shown of the container feed wheel 3 at a hand-over position b of the feed conveyer 2. The container 25 is fed to the conveyer wheel 4 at a hand-over position d of the inner conveyer passage 9 of the conveyer wheel 4 having a contacting rotary track. Thus, the container feed wheel 3 successively feeds the containers 25 to the container support portions 9a; i.e., the container support portions 9a are successively fed with the containers.
The inner conveyer passage 9 rotates in the direction of the arrow e, and conveys the containers 25 to the hand-over area f where the introduction/discharge devices 5 and 6 grip the containers 25 in the container support portions 9a, and turn the containers 25 by 180 degrees from their erected attitude.

The rotary body 14 turns every predetermined cycle each by 90 degrees from the first stage toward the fourth stage shown in Fig. 2. In the first stage as shown in Fig. 3, the chamber body 16 is at the ascended position and the rotary body 14 does not rotate at the moment of handing over the container 25. In the first stage shown in Fig. 2, if there is a container 25 that has been vapor-deposited in the preceding step, the introduction/discharge devices 5 and 6 take out the vapor-deposited container 25 from the chamber body 16 in advance, and hand the container 25 over to the outer conveyer passage 10. Thereafter, the introduction/discharge devices 5 and 6 take out the container 25 from the inner conveyer passage 9, and feed it in an inverted state onto the base plate 17 so that the mouth portion of the container 25 is supported by the container support portion 28 as shown in Fig. 5. The first stage is completed at a moment when the containers 25 are handed over between the two base plates 17 and the conveyer wheel 4. At the start of the vapor deposition operation, no container 25 has been held in the chamber body 16 and, therefore, the container 25 is simply fed. Thereafter, the rotary body 14 is turned by 90 degrees, and the containers 25 are fed to the succeeding chamber bodies 16 and are discharged therefrom according to the same procedure; i.e., the containers 25 are fed to, and discharged from, the two chamber bodies 16 each time, successively.

In the second stage (pressure pre-reducing zone), the chamber bodies 16 are descended by the lift unit 18, and are brought in contact and linked to the base plates 17 to seal the treating chambers 24 formed thereby. Next, the interiors of the treating chambers 24 are discharged by the vacuum pump 95 that is continuously running via the intake/exhaust port 31 and, at the same time, the interiors of the containers 25 are discharged by the vacuum pump 95 via the intake/exhaust port 29. Owing to the vacuum shielding plate 32b, the R-type (R-shaped) flange portion 32a does not lose air-tightness. The vapor deposition units 15 are conveyed in a pre-exhausted state to the position of a third stage (vapor deposition zone) where the microwave oscillators 34 are disposed.

In the third stage, the four vapor deposition units 15 are transferred to their corresponding microwave oscillators 34, whereby the microwave oscillators 34 are opposed close to the waveguides 32 of the chamber bodies 16. In the third stage, the interiors of the treating chambers 24 and the containers 25 are evacuated and exhausted by the vacuum pumps 96 and 97 that are running continuously.
Simultaneously with the evacuation and exhaustion, the starting material gases for vapor deposition are fed from the staring material gas feed pipes 30. As the starting material gases, O₂ is fed from the starting material gas container 82 shown in Fig. 11 and HMDSO (hexamethyldisiloxane) is fed from the starting material gas tank 84. After the starting material gases are fed, microwaves are oscillated to form a film. That is, the microwave oscillator power source 35 supplies the electric power to the microwave oscillators 34 to oscillate microwaves which are then transmitted into the containers through the waveguides 32 to generate a plasma in the containers 25 to thereby form a thin film. Since one container 25 is vapor-deposited in the treating chamber 24, the film can be evenly vapor-deposited.
After the plasma treatment has been completed, the starting material gases for treatment and microwaves are no longer introduced. The third stage is completed after the completion of vapor deposition on the containers 25, and the vapor deposition units are rotated by 90 degrees.

In the fourth stage (reduced pressure release zone), the atmosphere release valve 87 connected to the base plate 17 is opened to introduce the atmosphere from the inlet flow passage 91 communicated with the intake/exhaust port 29 to thereby return the interior of the container 25 to normal pressure. At the same time, the atmosphere release valve 88 is opened to introduce the atmosphere from the intake flow passage 86 communicated with the intake/exhaust port 31 to return the interior of the treating chamber 24 to normal pressure. Thereafter, the chamber bodies 16 are moved to the ascended position by the lift unit 18. Thus, the fourth stage is completed to complete the step of the vapor deposition treatment.
After the fourth stage has been completed, the rotary bodies 14 are rotated by 90 degrees, the containers 25 are handed from the chamber bodies 16 over to the conveyer wheel 4 by the introduction/discharge devices 5 and 6, and the operation of the above-mentioned first stage is repeated.
While the containers 25 have been fed onto, and taken out from, the base plates 17 in the first stage, the operation of vapor deposition on the containers 25 is, at the same time, conducted in the third stage on the opposite side of the rotary body 14. At the same time, on both sides of the first stage, i.e., in the second stage, the chamber bodies 16 are descended and the pre-exhaustion is conducted while in the fourth stage, the pressures are released to the atmosphere and, thereafter, the chamber bodies 16 are ascended.
The period for rotating the rotary bodies 14 is based on the time of vapor deposition operation in the third stage, and the rotary bodies 14 are rotated by 90 degrees each time.

Referring to Fig. 1, the introduction/discharge devices 5 and 6 hand over the containers 25 in the hand-over areas f and h of the conveyer wheel 4. In the conveyer hand-over area h, the introduction/discharge devices 5 and 6 hand the two containers 25 over to every other container support portions 10a placing an empty container holding portion 10a in between. In the container hand-over area f, the introduction/discharge devices 5 and 6 receive the containers 25 from the four container support portions 9a that are conveyed consecutively.
The outer conveyer passage 10 rotates in the direction of the arrow e to convey the containers 25 and hands the containers 25 at the hand-over position i over to grip means that are not shown of the container discharge wheel 7. The container discharge wheel 7 rotates in the counterclockwise direction of the arrow j and hands over the containers 25 at the hand-over position k of the discharge conveyer 8. The discharge conveyer 8 conveyers the containers 25 in the linear direction of the arrow m to feed the containers 25 to the next step.

### [Examples]

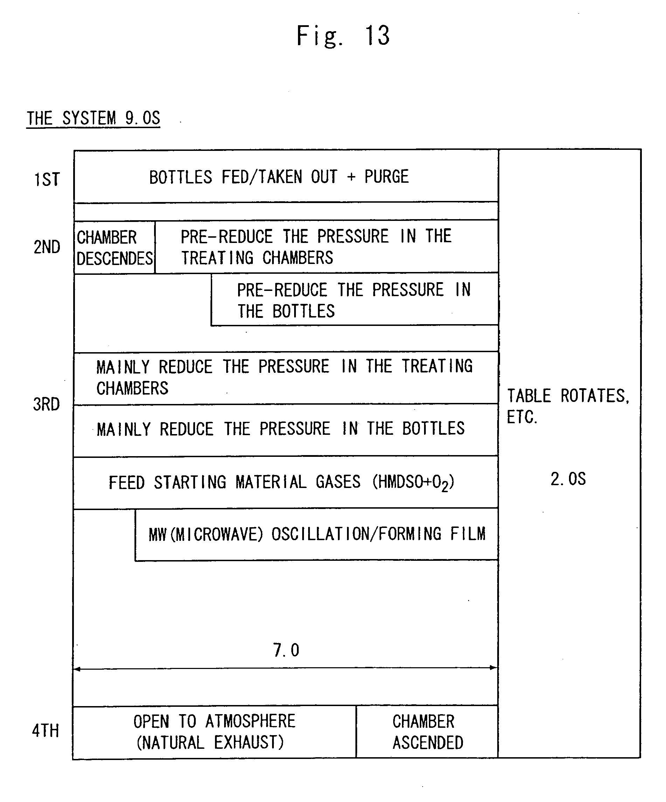

In this embodiment as shown in Fig. 13, the interiors of the treating chambers 24 and the containers 25 are evacuated and discharged being divided into two times. In the second stage, the interiors of the treating chambers 24 and the containers 25 are pre-exhausted and in the third stage, the evacuation and exhaustion are conducted so as to mainly reduce the pressure. Thus, the treating chambers 24 and the containers 25 are evacuated in advance so that spaces therein can be quickly evacuated down to a predetermined reduced pressure. As a result, the vapor deposition by microwaves can be completed substantially in 7.0 seconds from when the evacuation and exhaustion are effected.

Of the first stage through up to the fourth stage, the third stage requires the longest period of time, i.e., 7.0 seconds as described above. The operation times in the first, second and fourth stages are all within 7.0 seconds. As described above, therefore, a period of 7.0 seconds is required for effecting the vapor deposition on a container. In this embodiment, the step is divided to conduct the operation by a rotary system of 90 degrees each time. Therefore, while the vapor deposition operation is conducted in the third stage, the pressures are released to the atmosphere in the fourth stage. Thus, the stage is divided into four steps, and the time in each stage is set to meet the vapor deposition vacuum treatment which requires the longest period of time. In the third stage, the pressures are not released to the atmosphere, but the reduction of pressure and vapor deposition operation only are executed in an attempt to shorten the operation time.
In Fig. 13, rotating the table, etc. stand for a time required for rotating the rotary body 14 as well as for operating the air pressure circuits.

### [Experiments]

The following experiment deals with the pre-exhausting operation in the second stage and the evacuating/exhausting operation in the third stage of the invention enabling the vapor deposition time to be greatly shortened.

Described below is the procedure of pressure-reducing treatment by pre-exhaust in the second stage.

### [At the time of start (connect the base plates 17 to the vacuum exhaust system 61)]

The vacuum valve portion 64 is closed from the state shown in Fig. 6, the upper plate 62 is moved up to connect the base plates 17 to the vacuum exhaust system 61, and the vacuum shut-off valve 43 in the slide valve portion 40 is opened.

### [Starting the pre-exhaust]

In the above state of start, the vacuum valve portion 64 is opened from its closed state. Here, the treating chamber 24, interior of the container 25, flow passages 41a to 41c and flow passage 65 are communicated with each other, and the pressures in the treating chamber 24 and the container 25 are reduced by the vacuum pump 95.

### [Preparation for separating the base plate 17 from the vacuum exhaust system 61]

After the pre-discharge, the vacuum valve portion 64 is closed from its opened state. Next, the slide valve portion 40 is closed.

### [Separation of the base plates 17 from the vacuum exhaust system 61]

The upper plate 62 is moved down, and the base plates 17 are separated away from the vacuum exhaust system 61. The rotary bodies 14 is rotated, and the base plates 17 (vapor deposition units 15) are transferred to the third stage.
In this state, the base plates 17 are separated away from the vacuum exhaust system 61 in the second stage and, therefore, the flow passages 41a to 41c of the base plates 17 on the side of the lower end openings 43a to 43c of the vacuum shut-off valve 43 assume the atmospheric pressure.

When the bases plate 17 are transferred to the third stage accompanying the turn of the rotary bodies 14, the base plates 17 are positioned just over the upper plate 72 of the vacuum exhaust system 71 of the third stage, and the pressure-reducing operation is effected to mainly reduce the pressure.
Described below with reference to Fig. 9 and Fig. 10 is the procedure of the pressure-reducing processing by main pressure reduction.

### [Connect the base plates 17 to the vacuum exhaust system 71]

In a state where the pre-exhaust is completed, the vacuum shut-off valve 43 in the slide valve portion 40 on the side of the base plates 17 is in the closed state, and this state is further maintained. Thereafter, the vacuum valve portions 74a to 74c in the vacuum exhaust system 71 are closed, and the upper plate 72 is moved from the descended position to the ascended position to connect the base plates 17 to the vacuum exhaust system 71.

### [Starting the evacuation and exhaustion]

The vacuum valve portions 74a to 74c are opened from their closed state, and the flow passages 41a to 41c on the side of the base plates 17 are communicated with the flow passages 75a to 75c in the vacuum exhaust system 71. With the slide valve portion 40 on the side of the base plates 17 being closed, the pressures in the flow passages 41a to 41c and the flow passages 75a to 75c communicated therewith are reduced by the vacuum pumps 96 and 97 connected to the flanges 59a to 59c.

### [Completion of connection of vacuum/exhaustion]

After the pressures are reduced in advance in the flow passages 41a to 41c and in the flow passages 75a to 75c, the slide valve portion 40 is opened from its closed state, and the pressures in the treating chambers 24 and in the containers 25 are further reduced.

Concerning that the flow passages 41a to 41c assume the atmospheric pressure at the time when the base plates 17 are separated from the vacuum exhaust system 61 and the base plates 17 are connected to the vacuum exhaust system 71, a testing was conducted to examine a cycle time in a cycle and the effect in the cycle while arbitrarily varying the standby time required therefor. The standby time is a time from when the vacuum valve portions 74a to 74c are opened until when the slide valve portion 40 is opened and is, hereinafter, referred to as standby time X.
The tested results were as described below.

### [Tested results]

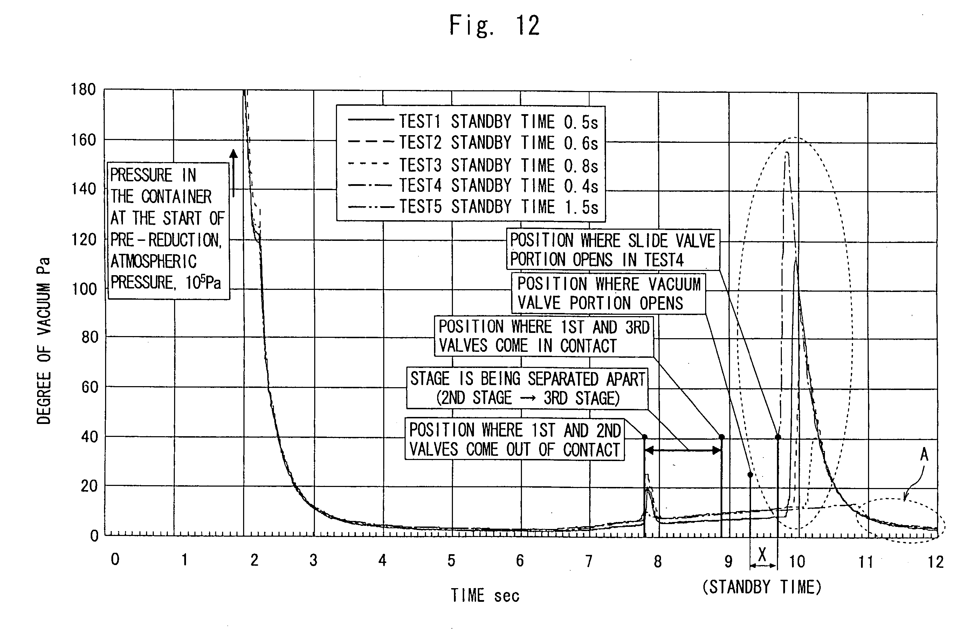

The standby time X was varied in a manner of 0.5 seconds, 0.6 seconds, 0.8 seconds, 0.4 seconds and 1.5 seconds, and the flow passages 41a to 41c that assumed the atmospheric pressure were exhausted in this order to measure the degrees of vacuum in the container 25. The tested results were as shown in Fig. 12. At the start of pre-reducing the pressure in Fig. 12, the pressure in the container 25 was normal pressure (about 1 x 10⁵ Pa).
As represented by an oval dotted line in Fig. 12, it was learned that the pressure in the container 25 increased with a decrease in the standby time X. That is, as a result of separating the base plate 17 from the vacuum exhaust system 61, an increased period of time is required for reducing the pressure in the flow passages 41a to 41c that have assumed the atmospheric pressure. If the standby time X is short, therefore, the container 25 is connected to the flow passages 41a to 41c while the pressures in the flow passages 41a to 41c and in the flow passages 75a to 75c have not been sufficiently reduced. At the start of vapor deposition, however, the degrees of vacuum become nearly in agreement without affected by the standby time X as represented by an arrow A in Fig. 12. It is, therefore, learned that the degree of vacuum is not affected even if the standby time X is shortened. Accordingly, it is learned that there is no problem even if the pressures are reduced being divided into the second stage and the third stage.

An embodiment of the invention was described above in detail with reference to the accompanying drawings. However, it should be noted that the invention is in no way limited to the above embodiment only but can, further, be varied or modified in other ways without departing from the scope of the invention.
In the above embodiment, the pressures in the treating chambers 24 and in the containers 25 were reduced by using separate vacuum pumps, i.e., by using two vacuum pumps 96 and 97. Depending upon the contents on which the vapor is to be deposited, however, the pressures in the treating chambers 24 and in the containers 25 may be reduced by using one vacuum pump as in the second stage. Further, the pressures in the four treating chambers 24 and the four containers 25 were reduced by using one vacuum pump. Though the facility cost becomes expensive, however, it is also possible to reduce the pressures in the treating chambers 24 and in the containers 25 independently each by using one vacuum pump.

The above embodiment has employed one vapor deposition apparatus 1 for easy explanation. In practice, however, a total of five vapor deposition apparatuses 1 have been disposed surrounding the conveyer wheel 4. Upon arranging the vapor deposition apparatuses 1 in a plural number as described above, the production of the containers can be continued even if, for example, any one of the vapor deposition apparatuses becomes inoperative due to the maintenance or defect while operating other vapor deposition apparatuses. Among the four microwave oscillators 34, furthermore, even if one of them becomes defective, the operation can be continued to deposit vapors on the containers 25 by using the remaining three microwave oscillators 34. When only one vapor deposition apparatus 1 is used as shown in Fig. 1, further, the apparatus can be realized in a compact size.
Though the above embodiment has used the microwave oscillator 34 which is the electromagnetic wave oscillator to vapor-deposit the starting materials on the containers 25, it is also allowable to use a high-frequency oscillator in its place.

## Claims

1. A vapor deposition apparatus comprising:
a support plate capable of intermittently rotating;
a plurality of vapor deposition units equipped with a treating chamber that can be opened and closed being arranged on said support plate in the circumferential direction thereof maintaining a distance so as to be successively positioned in an introduction/discharge zone, a pressure pre-reducing zone, a vapor deposition zone and a reduced pressure release zone accompanying the intermittent rotation of said support plate;
to-be-vapor-deposited body introduction/discharge means which discharges a body on which a thin film has been vapor-deposited from said treating chamber of said vapor deposition unit positioned in said introduction/discharge zone and introduces a to-be-vapor-deposited body on which a thin film is to be vapor-deposited into said treating chamber of said vapor deposition unit from which the to-be-deposited body has been discharged;
pressure pre-reducing means for exhausting the interior of said treating chamber of said vapor deposition unit positioned in said pressure pre-reducing zone to reduce the pressure therein;
vapor deposition means including main pressure-reducing means for exhausting the interior of said treating chamber to reduce the pressure therein to vapor-deposit a film on the to-be-vapor-deposited body present in said treating chamber of said vapor deposition unit positioned in said vapor deposition zone, gas feed means for feeding a gas necessary for vapor-depositing a film into said treating chamber, and electromagnetic wave generating means for generating electromagnetic waves in said treating chamber; and
reduced pressure release means for releasing the state of a reduced pressure in said treating chamber of said vapor deposition unit positioned in said reduced pressure release zone.

2. The vapor deposition apparatus according to claim 1, wherein said vapor deposition unit includes a base plate and a chamber body, said chamber body moves up and down with respect to said base plate to specify a close position where said treating chamber is closed and an open position where said treating chamber is opened, said chamber body moves to said close position while said vapor deposition unit is moving from said introduction/discharge zone to said pressure pre-reducing zone or after said vapor deposition unit is positioned in said pressure pre-reducing zone, and said chamber body moves to said open position after said vapor deposition unit is positioned in said reduced pressure release zone.

3. The vapor deposition apparatus according to claim 1 or 2, wherein the pressure pre-reducing means comprises:
a first flow passage arranged in said base plate of said vapor deposition unit, and is communicated at the one end thereof with said treating chamber, is opened at the other end thereof, and has first opening/closing valve means on the way thereof;
a second flow passage arranged in a first vacuum exhaust system, and is opened at the one end thereof, communicated at the other end thereof with a first vacuum source, and has second opening/closing valve means on the way thereof; and
a first moving member which enables said first flow passage and said second flow passage to be so positioned as connected to each other or disconnected from each other;
wherein at the time of reducing the pressure in said treating chamber of said vapor deposition unit positioned in said pressure pre-reducing zone, said first opening/closing valve means and said second opening/closing valve means are opened from a state where said first opening/closing valve means is closed, said second opening/closing valve means is closed and said first flow passage and said second flow passage are connected together by said first moving member and, thereafter, at the time of moving said vapor deposition unit from said pressure pre-reducing zone to said vapor deposition zone, said first and second opening/closing valve means are closed, respectively, and, thereafter, said first flow passage and said second flow passage are disconnected from each other by said first moving member.

4. The vapor deposition apparatus according to claims 1 to 3, wherein said main pressure reducing means comprises:
a first flow passage arranged in said base plate of said vapor deposition unit, and is communicated at the one end thereof with said treating chamber, is opened at the other end thereof, and has first opening/closing valve means on the way thereof;
a third flow passage arranged in a second vacuum exhaust system, and is opened at the one end thereof, communicated at the other end thereof with a second vacuum source, and has third opening/closing valve means on the way thereof; and
a second moving member which enables said first flow passage and said third flow passage to be so positioned as connected to each other or disconnected from each other;
wherein at the time of reducing the pressure in said treating chamber of said vapor deposition unit positioned in said main pressure reducing zone, said third opening/closing valve means is opened from a state where said first opening/closing valve means is closed, said third opening/closing valve means is closed and said first flow passage and said third flow passage are connected together by said second moving member and, next, said first opening/closing valve means is opened, and, thereafter, at the time of moving said vapor deposition unit from said vapor deposition zone to said reduced pressure release zone , said first and second opening/closing valve means are closed, respectively, and, thereafter, said first flow passage and said third flow passage are disconnected from each other by said second moving member.

5. The vapor deposition apparatus according to any one of claims 1 to 4, wherein said to-be-vapor-deposited body is a synthetic resin container, and a thin film is vapor-deposited on the whole inner surface of said container.
